Europäisches Patentamt

European Patent Office

Office européen des brevets

(11) Veröffentlichungsnummer: **0 359 836 B1**

(12) **EUROPÄISCHE PATENTSCHRIFT**

(45) Veröffentlichungstag der Patentschrift: **18.11.93**

(21) Anmeldenummer: **88115132.8**

(22) Anmeldetag: **15.09.88**

(51) Int. Cl.⁵: **H04B 10/14**, H03F 3/08, H03G 3/20

(54) Schaltungsanordnung mit einem an einen opto-elektrischen Wandler angeschlossenen Verstärker.

(43) Veröffentlichungstag der Anmeldung:
**28.03.90 Patentblatt 90/13**

(45) Bekanntmachung des Hinweises auf die
Patenterteilung:
**18.11.93 Patentblatt 93/46**

(84) Benannte Vertragsstaaten:
**AT BE CH DE FR GB IT LI NL SE**

(56) Entgegenhaltungen:
**EP-A- 0 102 174**
**EP-A- 0 181 146**
**GB-A- 2 105 543**
**US-A- 3 631 262**

**JOURNAL OF LIGHTWAVE TECHNOLOGY,
Band LT-4, Nr. 10, Oktober 1986, Seiten
1502-1508, IEEE, New York, NY, US; G.F. WIL-
LIAMS et al.: "Active feedback lightwave receivers**

(73) Patentinhaber: **SIEMENS AKTIENGESELL-
SCHAFT**
**Wittelsbacherplatz 2**
**D-80333 München(DE)**

(72) Erfinder: **Prasse, Karl-Heinz, Dipl.-Ing.
Am oberen Rain 14
D-8102 Mittenwald(DE)**
Erfinder: **Danzer, Hermann, Dipl.-Ing.
Lenangasse 3
D-3400 Weidling(AT)**

**Beschreibung**

Die Erfindung bezieht sich auf eine wie im Oberbegriff des Patentanspruchs 1 angegebene Schaltungsanordnung mit einem an einen opto-elektrischen Wandler angeschlossenen Verstärker, insbesondere Transimpedanzverstärker.

Eine derartige Schaltungsanordnung ist bereits aus der GB-A-2 105 543 bekannt. Die bekannte Schaltungsanordnung enthält einen Verstärker mit steuerbarer Verstärkung, der mit seinem Eingang an einen opto-elektrischen Wandler angeschlossen und mit einem zwischen seinem Signalausgang und seinem Signaleingang angeordneten Rückkopplungszweig versehen ist. An den Ausgang des Verstärkers ist ein Integrator angeschlossen. Zwischen dem Signaleingang des Verstärkers und dem Ausgang des Integrators ist die Drain-Source-Strecke eines Feldeffekttransistors angeordnet. Die Steuerelektrode dieses Feldeffekttransistors ist an einen von zwei Steuerausgängen eines Reglers angeschlossen, dessen Eingang am Ausgang des Verstärkers liegt. Für Fotoströme unterhalb einer Schwelle gibt der Regler an die Steuerelektrode des Feldeffekttransistors eine Steuerspanung ab, die diesen sperrt. Für Fotoströme oberhalb der Schwelle wird der Feldeffekttransistor leitend gesteuert, derart, daß sich eine automatische Verstärkungsregelung ergibt. Die Drain-Source-Strecke des Feldeffekttransistors bildet dabei einen parallel zum Signaleingang des Verstärkers liegenden steuerbaren Widerstand. Bei einer Ausführungsform der bekannten Schaltungsanordnung ist der Rückkopplungszweig über eine RC-Parallelschaltung geführt.

Befindet sich der Feldeffekttransistor im leitenden Zustand, gelangt der vom Integrator gebildete Gleichspannungsanteil des Verstärker-Ausgangssignales an den Eingang des Verstärkers. Die Gegenkopplung über die RC-Parallelschaltung ist für Gleich- und Wechselstrom wirksam.

Ferner ist aus der DE-C-32 04 839 eine Schaltungsanordnung bekannt, die am Eingang eine Fotodiode hat und eine Kettenschaltung aus einer Emitterstufe und einer Kollektorstufe enthält. Zwischen dem Ausgang der Kollektorstufe und dem Eingang der Emitterstufe ist in einem Gegenkopplungszweig ein Widerstand angeordnet. Diese aus zwei Stufen bestehende Schaltungsanordnung bildet einen sogenannten Transimpedanzverstärker, der einen vergleichsweisen kleinen Eingangswiderstand und einen vergleichsweise sehr niedrigen Ausgangswiderstand hat.

Parallel zum Kollektorwiderstand der Emitterstufe liegt die Drain-Source-Strecke eines Feldeffekttransistors, dessen Widerstand mit Hilfe einer Steuerspannung kontinuierlich steuerbar ist. Auf diese Weise läßt sich der effektive Kollektorwiderstand in weiten Grenzen ändern. Damit ergibt sich eine Möglichkeit einer externen Einstellung des Verstärkungsgrades der ersten Verstärkerstufe innerhalb eines relativ großen Dynamikbereichs. Allerdings wird dabei durch die Verstärkungsregelung der Gleichstromarbeitspunkt der Verstärkeranordnung beeinflußt.

Die bekannte Schaltungsanordnung soll außerdem die üblichen Anforderungen hinsichtlich rauschoptimaler Auskopplung der vom Photoempfänger abgegebenen elektrischen Signale, hoher Verstärkung und geringer Stromaufnahme zusammen mit einem möglichst kleinen Eigenrauschen aufweisen.

Aufgabe der Erfindung ist es, eine Schaltungsanordnung der eingangs genannten Art derart auszubilden, daß sich innerhalb eines großen Dynamikbereiches der Verstärkung günstige Werte der Verstärkerrauschzahl und ein günstiger Frequenzgang der Verstärkung ergeben. Insbesondere soll die Grenzfrequenz der Verstärkung bei einer Steuerung der Verstärkung zu kleineren Werten hin möglichst nicht abnehmen.

Gemäß der Erfindung wird die Schaltungsanordnung zur Lösung der gestellten Aufgabe in der im kennzeichnenden Teil des Patentanspruchs 1 angegebenen Weise ausgebildet. Dabei ergibt sich, daß der Rückkopplungswiderstand durch den in Serie angeordneten Kondensator für Gleichstrom entkoppelt ist und daß die Verstärkungsregelung den Gleichstromarbeitspunkt des Verstärkers nicht beeinflußt.

Durch die erfindungsgemäßen Maßnahmen ergibt sich der Vorteil, daß sich der Bahnwiderstand des Feldeffekttransistors auf einfache Weise mit Hilfe einer Steuerspannung einstellen läßt und die zur Steuerung der Verstärkung vorgesehenen Maßnahmen praktisch keine Verschlechterung der Verstärkerrauschzahl oder des Frequenzganges der Verstärkung bewirken, wenn die Schaltungsanordnung auf maximale Verstärkung eingestellt wird.

Vorteilhafte weitere Ausgestaltungen der Erfindung ergeben sich aus den abhängigen Patentansprüchen 2 und 3.

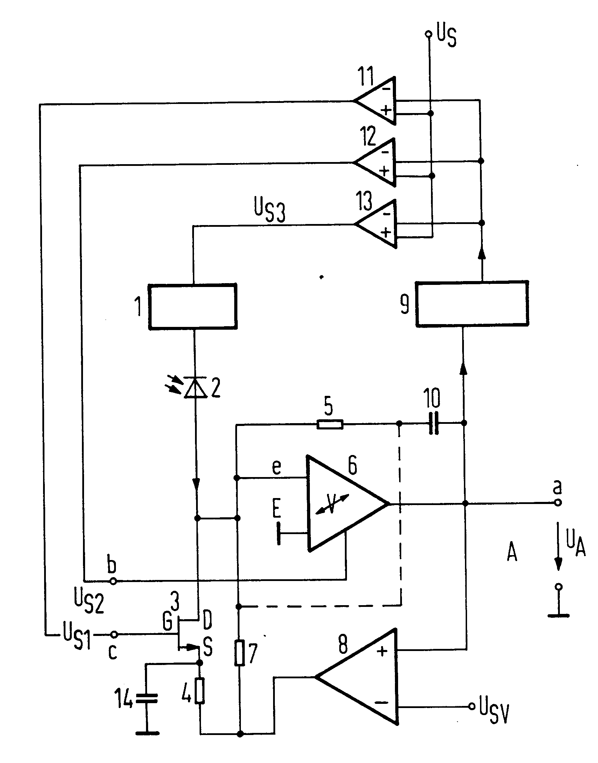

Die Erfindung wird anhand des in der Figur dargestellten Ausführungsbeispieles näher erläutert.

Die Figur zeigt eine Schaltungsanordnung mit einem an einen opto-elektrischen Wandler angeschlossenen, hinsichtlich seiner Verstärkung steuerbaren Verstärker.

Die in der Figur gezeigte Schaltungsanordnung enthält einen Verstärker 6, der an die Fotodiode 2, insbesondere eine Lawinenfotodiode, angeschlossen ist. Die in der Figur gezeigte Schaltungsanordnung enthält den Verstärker 6, der einen unsymmetrischen Signaleingang E und einen unsymmetrischen Signalausgang A aufweist. Der gegen Bezugspotential bzw. Masse Spannung führende Anschluß e des Signaleingangs E ist an die Anode der Fotodiode 2 angeschlossen. Der gegen Bezugspotential Spannung führende Anschluß a des Ausgangs A ist über den Kondensator 10 und den dazu in Serie liegenden Widerstand 5 an den Anschluß e des Signaleingangs E geführt.

Außerdem ist der Istwerteingang "+" des Vergleichers 8 an den Anschluß a des Signalausgangs A angeschlossen. Am Sollwerteingang "-" des Vergleichers 8 liegt die Sollspannung $U_{SV}$. Der Ausgang des Vergleichers 8 ist über den Widerstand 7 an den Anschluß e des Signaleingangs E geführt. Der dem Ausgang des Vergleichers 8 abgewandte Anschluß des Widerstandes 7 kann gegebenenfalls anstatt an den Eingang e an den Verbindungspunkt des Widerstandes 5 mit dem Kondensator 10 angeschlossen sein. Parallel zum Eingang E liegt die aus dem Widerstand 4 und der Source-Drain-Strecke des Feldeffekttransistors 3 bestehende Serienschaltung.

Am Anschluß a des Signalausgangs A liegt die Vorrichtung 9 zur Spitzenwertgleichrichtung. Die drei Regelverstärker 11, 12 und 13 sind jeweils mit ihrem Istwerteingang "-" an den Ausgang der Vorrichtung 9 angeschlossen. Die Sollwerteingänge "+" der Regelverstärker 11, 12 und 13 liegen gemeinsam an der Vorspannung $U_S$, so daß sich die Regelbereiche der Regelverstärker 11, 12 und 13 wenigstens teilweise überlappen. Gegebenenfalls können die Regelverstärker mit je einer eigenen Vorspannungsquelle versehen sein. Die Ausgänge der Regelverstärker 11 und 12 sind an die Anschlüsse c und b für die Steuerspannungen $U_{S1}$ und $U_{S2}$ geführt. Am Ausgang des Regelverstärkers 13 liegt die Steuerspannung $U_{S3}$.

Die Vorrichtung 1 zur Vorspannungserzeugung ist an den Regelverstärker 13 angeschlossen. An ihrem Ausgang liegt die Kathode der Fotodiode 2. Die Vorrichtung 1 zur Vorspannungserzeugung ist ein geregelter Gleichspannungswandler, der die vergleichsweise hohe Vorspannung der Fotodiode 2 liefert. Der Regelverstärker 13 sorgt dafür, daß die Vorspannung in der gewünschten Weise geregelt wird.

Der Verstärker 6 läßt sich mit Hilfe der Steuerspannung $U_{S2}$ hinsichtlich seiner Verstärkung steuern. Die Steuerelektrode des Feldeffekttransistors 3 ist mit dem Anschluß c für die Steuerspannung $U_{S1}$ verbunden. Die Sourceelektrode des Feldeffektransistors 3 liegt über den Kondensator 14 wechselspannungsmäßig an Masse.

Die in der Figur gezeigte Schaltungsanordnung gestattet es, die Verstärkung innerhalb eines großen Bereiches kontinuierlich zu regeln. Der Arbeitspunkt bleibt dabei in vorteilhafter Weise konstant.

Der Verstärker 6 ist ein Verstärker mit einer Verstärkerstufe steuerbarer Verstärkung. Zur Steuerung der Verstärkung wird der Arbeitswiderstand der Verstärkerstufe und damit die Verstärkung verändert. Diese Art der Verstärkungsänderung ist bereits aus der DE-C-32 04 839 bekannt. Die Veränderung des Arbeitswiderstandes kann mittels eines Feldeffekttransistors oder mit Hilfe von PIN-Dioden vorgenommen werden, deren Widerstandswert durch die Steuerspannung $U_{S2}$ gesteuert wird.

Bei der Schaltungsanordnung nach der Figur wird in vorteilhafter Weise verhindert, daß bei zunehmendem Eingangsstrom I der volle Strom I durch den Rückkopplungswiderstand 5 fließen muß. Dieser Strom wird über den Feldeffekttransistor 3, der parallel zum Eingang des Verstärkers 6 angeordnet ist, abgeleitet. Bei Verwendung eines Feldeffekttransistors 3 mit geringen Kapazitäten, sowie durch den im M $\Omega$ -Bereich liegenden Sperrwiderstand üblicher Feldeffekttransistoren ist sichergestellt, daß bei eingestellter maximaler Verstärkung die Maßnahmen, die eine Herabsetzung der Verstärkung ermöglichen, keine wesentliche Verschlechterung der Rauschzahl und des Frequenzganges der Schaltungsanordung bewirken.

Eine weitere Regelschaltung sorgt dafür, daß der Arbeitspunkt der Schaltungsanordnung konstant bleibt, d. h. daß die Verstärkungsregelung den Gleichstromarbeitspunkt der Verstärkeranordnung nicht beeinflußt. Dazu wird der Rückkopplungswiderstand 5 durch Serienschaltung des Kondensators 10 für Gleichstrom entkoppelt.

Mit Hilfe des Vergleichers 8 wird die Ausgangsgleichspannung des Verstärkers 6 mit der Sollwertspannung $U_S$ verglichen. Mit Hilfe des Vergleichers 8 wird die Vorspannung am Signaleingang E solange verändert, bis Sollwert und Istwert miteinander übereinstimmen. Auf diese Weise wird bei wechselnden Eingangsströmen I der Arbeitspunkt des Verstärkers 6 konstant gehalten.

Abweichend von der Figur kann der Ausgang des Vergleichers 8 direkt mit dem Anschluß e verbunden werden. Der Widerstand 7 hat jedoch in Verbindung mit dem Widerstand 4 den Vorteil, daß der Strom I zwischen dem Widerstand 7 und dem Feldeffekttransistor 3 in der Weise aufgeteilt wird, daß der Feldeffekttransistor 3 immer im Widerstandsbetrieb bleibt und daß außerdem die Spannung an der Sourceelektrode des Feldeffekttransistors 3 konstant gehalten wird. Durch die konstante Spannung an der Sourceelektrode ist eine einfache Regelung des Bahnwiderstandes $R_{DS}$ des Feldeffekttransistors 3 mit der Gate-Source-Spannung $U_{GS}$, d. h. mit der Steuerspannung $U_{S1}$ möglich.

Die Verstärkungsregelung kann vereinfacht wie folgt berechnet werden, wobei mit

UA        die Ausgangsspannung,

$R_K$        der Wert des Widerstandes 5

$V_O$        Verstärkung des unbeschalteten bzw. offenen Verstärkers

$R_{DS}$ Widerstand der Drain-Source-Strecke des Feldeffekttransistors 3

$R_{ON}$ der Widerstand der Source-Drain-Strecke des Feldeffekttransistors 3 im leitend gesteuerten Zustand

$\omega_v$ die Grenzfrequenz des unbeschalteten Verstärkers 6

$\omega_{gp}$ die durch die Eingangsschaltung gebildete Grenzfrequenz ist.

$$\frac{U_a}{I} = -R_K \frac{1}{1 + \frac{1}{v_o}\left(\frac{R_K}{R_{DS}} + 1\right)}$$

Die maximale Verstärkung ergibt sich zu

$$\left(\frac{U_a}{I}\right)_{max} = R_k$$

wobei $R_{DS}$ gegen $\infty$ strebt.

Strebt $R_{DS}$ gegen $R_{ON}$, so ergibt sich die minimale Verstärkung mit $v_o = 1$ ergibt sich zu

$$\left(\frac{U_a}{I}\right)_{min} = R_{ON}$$

Bei einem bevorzugten Bemessungsbeispiel betragen

$$R_k = 10 \ k\Omega \qquad \frac{R_k}{R_{ON}} = 1000 \triangleq 3 \ \text{Dekaden}$$
$$R_{ON} = 10 \ \Omega$$

Auf diese Weise läßt sich z. B. eine Verstärkungsregelung über 3 Dekaden realisieren.

Wählt man die Grenzfrequenz $\omega_v$ des unbeschalteten Verstärkers so, daß sie höher liegt als die durch die Eingangsschaltung - d. h. (Eingangskapazität und Eingangswiderstand), gebildete Grenzfrequenz $\omega_{gp}$ so tritt bei einer Steuerung der Verstärkung zu kleineren Werten hin in vorteilhafter Weise nicht nur keine Verringerung sondern sogar eine Erhöhung dieser Grenzfrequenz ein.

Unter der Voraussetzung, daß der der unbeschaltete Verstärker 6 ein Tiefpaß 1. Ordnung mit der Grenzfrequenz $\omega_v$ ist, errechnet sich der Frequenzgang des beschalteten Verstärkers 6 abhängig vom Widerstand $R_{DS}$ folgendermaßen:

$$\frac{U_A}{I} = -\frac{R_K}{1 + \frac{v'}{v_o}} \frac{1}{1 + j\frac{\omega'}{\omega_v}\left(1 + \frac{v}{v'}\right)} \qquad \text{mit } v' = \frac{R_k}{R_{DS}} + 1$$

$$\omega'_g = \omega'_v \left(1 + \frac{v_o}{v'}\right)$$

Strebt $R_{FET}$ gegen $\infty$, so wirkt der Feldeffekttransistor 3 als Stromquelle und es wird $\omega_v = \omega_v (1 + v_o) > \omega_{gp}$

Strebt $R_{FET}$ gegen O, so wirkt der Feldeffekttransistor 3 als Spannungsquelle und es wird $\omega_g = \omega_v$ .

**Patentansprüche**

1. Schaltungsanordnung mit einem mit seinem Eingang (E) an einen opto-elektrischen Wandler (Fotodiode 2) angeschlossenen Verstärker (6), dessen Verstärkung mit Hilfe eines Stellgliedes steuerbar ist, mit einem zwischen dem Signalausgang (A) des Verstärkers (6) und dem Signaleingang (E) des Verstärkers (6) angeordneten Rückkopplungszweig, mit einem Feldeffekttransistor (3), dessen Drain-Source-Strecke parallel zum Signaleingang (E) des Verstärkers (6) angeordnet ist und dessen Bahnwiderstand mit Hilfe einer Steuerspannung einstellbar ist, und mit wenigstens einer an den Ausgang des Verstärkers (6) angeschlossenen Vorrichtung (9, 11, 12, 13) zur automatischen Verstärkungsregelung, wobei der Steuereingang (b) des Verstärkers und die Steuerelektrode des Feldeffekttransistors (3) jeweils an einen Ausgang der Vorrichtung (9) zur automatischen Verstärkungsregelung angeschlossen ist,
**dadurch gekennzeichnet,**
daß die Vorrichtung (9) zur automatischen Verstärkungsregelung als Vorrichtung zur Spitzenwertgleichrichtung ausgebildet ist, daß der Rückkopplungszweig durch eine RC-Serienschaltung (5, 10) gebildet ist, daß der Ausgang eines Vergleichers (8), der einen Eingang für die Ausgangsgleichspannung ($U_A$) des Verstärkers (6) und einen Eingang für eine Sollwertspannung ($U_S$) hat, jeweils über einen Widerstand (7, 4) mit dem Eingang (E) des Verstärkers (6) und der Sourceelektrode des Feldeffekttransistors (3) verbunden ist und daß mit Hilfe des Stellgliedes der Arbeitswiderstand des Verstärkers (6) veränderbar ist.

2. Schaltungsanordnung nach Anspruch 1,
**dadurch gekennzeichnet,**
daß der zwischen dem Ausgang des Vergleichers (8) und dem Eingang (E) des Verstärkers (6) liegende Widerstand (7) über den Widerstand (5) der RC-Serienschaltung (5, 10) an den Eingang (E) geführt ist.

3. Schaltungsanordnung nach Anspruch 1 oder 2,
**dadurch gekennzeichnet,**
daß die Fotodiode (2) an eine Vorrichtung (1) zur Vorspannungserzeugung angeschlossen ist, die durch die Vorrichtung (9, 11, 12, 13) zur automatischen Verstärkungsregelung steuerbar ist.

**Claims**

1. Circuit arrangement having an amplifier (6) which is connected by its input (E) to an optoelectrical transducer (photodiode 2) and the amplification of which is controllable by means of a control element, having a feedback branch which is disposed between the signal output (A) of the amplifier (6) and the signal input (E) of the amplifier (6), having a field effect transistor (3), the drain-source path of which is disposed in parallel with the signal input (E) of the amplifier (6) and the bulk resistance of which can be set by means of a control voltage, and having at least one device (9, 11, 12, 13), connected to the output of the amplifier (6), for automatic amplification regulation, in which the control input (b) of the amplifier and the gate electrode of the field effect transistor (3) are connected to a respective output of the device (9) for automatic amplification regulation, characterised in that the device (9) for automatic amplification regulation is designed as a device for peak-value rectification, in that the feedback branch is formed by an RC series circuit (5, 10), in that the output of a comparator (8) which has an input for the output direct voltage ($U_A$) of the amplifier (6) and an input for a theoretical value voltage ($U_S$), is connected in each instance via a resistor (7, 4) to the input (E) of the amplifier (6) and the source electrode of the field effect transistor (3), and in that the working resistance of the amplifier (6) is variable by means of the control element.

2. Circuit arrangement according to Claim 1, characterised in that the resistor (7) situated between the output of the comparator (8) and the input (E) of the amplifier (6) is passed via the resistor (5) of the RC series circuit (5, 10) to the input (E).

3. Circuit arrangement according to Claim 1 or 2, characterised in that the photodiode (2) is connected to a device (1) for bias generation, which is controllable by the device (9, 11, 12, 13) for automatic amplification regulation.

**Revendications**

1. Montage comportant un amplificateur (6) raccordé par son entrée (E) à un transducteur opto-électrique (photodiode 2) et dont l'amplification peut être commandée à l'aide d'un élément de réglage, comportant une branche de réaction disposée entre la sortie (A) du signal de l'amplificateur (6) et l'entrée (E) du signal de l'amplificateur (6), un transistor à effet de champ (3), dont la voie drain-source est branchée en parallèle avec l'entrée (A) du signal de l'amplificateur (6) et dont la résistance volumique peut être réglée à l'aide d'une tension de commande, et comportant au moins un dispositif (9,11,12,13) connecté à la sortie de l'amplificateur (6) et servant à régler automatiquement l'amplification, l'entrée de commande (b) de l'amplificateur et l'électrode de commande du transistor à effet de champ (3) étant raccordées respectivement à une sortie du dispositif (9) de réglage automatique de l'amplification, caractérisé par le fait que le dispositif (9) de réglage automatique de l'amplification est agencé sous la forme d'un dispositif de redressement des valeurs crêtes, que la branche de réaction est formée par un circuit série RC (5,10), que la sortie d'un comparateur (8), qui possède une entrée pour la tension continue de sortie ($U_A$) de l'amplificateur (6) et une entrée pour une tension de consigne ($U_S$), est respectivement reliée, par l'intermédiaire d'une résistance (7,4), à l'entrée (E) de l'amplificateur (6) et à l'électrode de source du transistor à effet de champ (3), et que la résistance de travail de l'amplificateur (6) est modifiable à l'aide du circuit de réglage.

2. Montage suivant la revendication 1, caractérisé par le fait que la résistance (7) située entre la sortie de l'amplificateur (8) et l'entrée (E) de l'amplificateur (6), est raccordée, par l'intermédiaire de la résistance (5) du circuit série RC (5,10), à l'entrée (E).

3. Montage suivant la revendication 1 ou 2 caractérisé par le fait que la photodiode (2) est raccordée à un dispositif (1) de production de la tension de polarisation, qui peut être commandé par le dispositif (9,11,12,13) de réglage automatique de l'amplification.